# EUROPEAN PATENT APPLICATION

(11) **EP 4 734 733 A1**
(43) Date of publication of application: **29.04.2026**
(21) Application number: 24472015.7
(22) Date of filing: 23.10.2024
(51) Int. Cl.: H10N 30/30, G01R 33/02, H10N 39/00, H10N 35/80

(54) **PASSIVE MAGNETO ELECTRIC TRANSDUCER**

(71) Applicant: Melexis Bulgaria EOOD, 1138 Sofia (BG)
(72) Inventor: Burssens, Jan-Willem c/o Melexis Technologies NV, 3980 Tessenderlo (BE); Van Der Wiel, Appo c/o Melexis Technologies NV, 3980 Tessenderlo (BE)
(74) Representative: Winger

(57) **Abstract**

A passive magneto-electric transducer comprises a piezoelectric layer and magnetic structures attached thereto with high permeability material. Strain can be generated between the structures on the piezoelectric layer when subjected to an external magnetic field. The piezoelectric layer is configured to generate charges as a response to its mechanical strain from the forces of the magnetic structures. At least one pair of electrodes are positioned to collect charges of opposite sign, generated by the piezoelectric layer, so that a signal can be provided by the transducer without external electrical power sources.

## Description

### Field of the invention

The present invention relates to the field of passive magneto-electric transducers, and more specifically to a transducer comprising a piezoelectric layer and magnetic structures for generating strain on the piezoelectric layer in response to an external magnetic field.

### Background of the invention

Magnetic sensing is an important technology used in various applications, such as magnetic switching and inertial navigation. However, power consumption remains a significant challenge in many of these applications, particularly in battery-powered devices and smartphones. Finding an optimal balance between power consumption and other sensing attributes, such as signal-to-noise ratio and output rate, is often difficult or even impossible for certain applications.

Magnetic switches are commonly used where mechanical contacts are undesirable due to issues with insulation, vibration, or reliability. Hall effect sensors are one technology used for magnetic switching. However, they have the disadvantages of high power consumption and requiring a low-voltage power supply, which may not always be available. Reed switches are another widely used technology, particularly in applications with mains voltage or where low energy consumption is critical. While reed switches dominate these markets, their glass capsule construction makes them fragile and vulnerable. There is a demand for more robust magnetic sensors that can simplify PCB assembly without requiring special handling.

Additionally, the bulky size of reed switches compared to Hall switches makes them difficult to integrate into space-constrained applications like wearables and smartwatches. Although low energy consumption is crucial in these applications, using a reed switch is often impossible due to size limitations. This creates a high demand for small form factor, passive magnetic sensors.

For inertial navigation applications, sensors are typically operated with very low duty cycles and output rates to limit power consumption, but this comes at the expense of reduced navigation accuracy. Various sensor technologies are used, such as TMR, GMR, and Hall plates, but they all require power to operate.

Existing technologies have limitations in addressing all market needs. Reed switches and micro-reed contacts provide passive switching but have reliability and size constraints. Active switches based on Hall plates consume significant power, while TMR sensor alternatives reduce current consumption but still require power.

In summary, there is a need for further advancements in magnetic sensing technology to address the challenges of power consumption, reliability, size, and performance across various applications. Developing a solution that can efficiently and reliably generate electrical signals from magnetic fields without external power could significantly improve magnetic switching and inertial navigation capabilities in power-constrained devices.

### Summary of the invention

It is an object of embodiments of the present invention to provide a magneto-electric transducer, for example a passive magneto-electric transducer. This objective is accomplished by the aspects of the present invention.

In the first aspect, the present invention relates to a transducer comprising:
- a piezoelectric layer,
- at least one pair of magnetic structures attached to the piezoelectric layer and comprising high permeability material, the structures defining a gap between them, and being shaped and positioned relative to each other, such that strain is generated therebetween on the piezoelectric layer when the pair of magnetic structures is subjected to an external magnetic field,
wherein the piezoelectric layer is configured to generate charges as a response to its mechanical strain from the forces of the magnetic structures,
- further comprising at least one pair of electrodes isolated by the piezoelectric material, each electrode of the pair being positioned to collect charges of opposite sign generated by the piezoelectric layer, so that a signal can be provided by the transducer without external electrical power sources, thus providing a passive magneto-electric transducer.

It is an advantage of embodiments of the present invention that passive magneto-electric transducer can be provided, which efficiently and reliably generates electrical signals from magnetic fields without the need for external power sources.

In embodiments, the transducer may further comprise lateral stress release cuts in the piezoelectric layer. The flexibility of the piezoelectric layer is thus increased. This allows the strain response to the magnetic forces to increase.

In embodiments, the transducer may further comprise a planar rigid substrate and a flexible layer sandwiched between the piezoelectric layer and the planar rigid substrate, for providing mechanical decoupling from the rigid substrate. This allows in-plane stress to be easily converted to out-of-plane stress thanks to the decoupling from the rigid substrate. It also enables the rigid substrate to be a semiconductor substrate including circuitry for redirecting and/or processing electric signal from the electrodes.

In embodiments, the flexible layer may comprise elastic polyimide, benzocylobutene, polybenzoxazole, acryl, fluoroslicone, silicone or siloxane.

In embodiments, a first electrode of the pair may be provided on a first surface of the piezoelectric layer between the pair of magnetic structures, and a second electrode may be provided on the opposite surface of the piezoelectric layer, between the flexible layer and the piezoelectric layer. This allows the electrodes to be isolated by the piezoelectric layer itself.

In embodiments, the electrodes may be shaped and positioned relative to magnetic structures so that, when the magnetic field is induced through said pair of magnetic structures, a force is generated between the structures for causing an out-of-plane strain to the piezoelectric layer at least in the region of the piezoelectric layer in electric contact with an electrode. This allows the alignment of all the electrodes to be done accurately on a single surface.

In embodiments, the magnetic structures may comprise Ni, Fe, Co or combinations thereof.

In embodiments, the at least one pair of magnetic structures may comprise an array of magnetic structures arranged so that strain is generated on the piezoelectric layer between pairs of the structures when the array is subjected to an external magnetic field. This allows high sensitivity to be achieved.

Optionally, the piezoelectric layer may comprise aluminum nitride and the electrodes may comprise TiPt.

In the second aspect, the present invention relates to a method of manufacture of a transducer in accordance with any embodiments of the first aspect, comprising:
- providing a piezoelectric layer,
- providing at least one electrode in direct contact with the surface of the piezoelectric layer,
- providing at least a pair of magnetic structures on the opposite side surface of the piezoelectric layer (thus, on the surface at the opposite side), defining a gap between the pair of structures, the structures being arranged so that the structures strain the piezoelectric layer when submitted to a magnetic field,
- connecting the at least one electrode to an output for reading the signals generated by the piezoelectric layer.

It is an advantage of embodiments of the present invention that the method can provide a transducer, e.g. passive transducer, easily, where electrodes are insulated by the piezoelectric layer itself.

In embodiments, the method may further comprise providing a rigid substrate and further providing a flexible layer between the piezoelectric layer and the rigid substrate. This allows a transducer to be provided with high sensitivity.

In embodiments, providing the flexible layer may comprise spin coating or laminating polymer on top of the substrate or on top of the piezoelectric layer. This allows a flexible layer to be provided easily.

In embodiments, providing the magnetic structures may comprise providing magnetic structures configured to provide in-plane stress to the piezoelectric layer and providing at least one electrode may comprise providing an electrode pair comprising a first electrode contacting a first surface of the piezoelectric layer, the first electrode being provided within the gap between said magnetic structures, and providing a second electrode contacting the second surface of the piezoelectric layer opposite to the first surface, wherein the first and second electrodes are positioned to collect charges of opposite sign generated at the piezoelectric layer. This allows a transducer to be provided with accurate capacitance between the electrodes stemming from the material and thickness of the piezoelectric layer.

In embodiments, providing the magnetic structures may comprise providing magnetic structures configured to provide out-of-plane stress to the piezoelectric layer, and providing at least one electrode may comprise providing an electrode pair comprising a first electrode and a second electrode contacting a first surface of the piezoelectric layer opposite to the second surface being the surface supporting the magnetic structures, wherein the first and second electrodes are positioned to collect charges of opposite sign from the piezoelectric layer. This allows the electrode pair to be accurately aligned and provided in a single step on one surface.

Optionally, the shear stress may be a torsional stress with a torsion axis parallel to the plane of the piezoelectric layer.

In embodiments, the method may further comprise providing a connection arranged to open or close a transistor. This allows a device for a switch to be provided.

In embodiments, the method may further comprise providing a connection for a sensor output stage. This allows a device for a sensor to be provided.

The method may comprise providing the different elements, e.g. piezoelectric layer, e.g. the electrodes, by sputtering, deposition, etc. It is an advantage of embodiments of the present invention that thin electrodes can be provided by well known techniques, including e.g. masking.

The method may comprise providing the magnetic structures by e.g. electroplating.

It is an advantage of embodiments of the present invention that passive magneto-electric transducers can be provided, which efficiently and reliably generate electrical signals from magnetic fields without the need for external power sources. It is an advantage of embodiments of the present invention that the strain response to magnetic forces increases due to the inclusion of lateral stress release cuts in the piezoelectric layer, enhancing flexibility. It is an advantage of embodiments of the present invention that in-plane stress can be easily converted to out-of-plane stress thanks to the decoupling from a rigid substrate via a flexible layer. It is an advantage that the electrodes are isolated by the piezoelectric layer itself.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 illustrates shows a layer of piezoelectric material at rest and with lateral stretch. The figure shows the force vectors (F) causing the stretching of the piezoelectric material, which generates an electric potential between the top and bottom regions of the piezoelectric material.
Fig. 2 shows a layout of an array of magnetic structures for generating a force on the anchoring surface of the piezoelectric layer when a magnetic field is applied in a given direction.
Fig. 3 shows a top view of a transducer in accordance with embodiments of the present invention with an arrangement of triangular magnetic structures aligned at each side of an electrode.
Fig. 4 shows a cross section of a transducer in accordance with embodiments of the present invention. The piezoelectrical layer converts the stresses that arise from the magnetic structures into a voltage. A potential is generated across the thickness of the piezoelectric layer. Thus, the piezoelectric layer behaves as a capacitor.
Fig. 5 shows two different capacitor configurations, depending on the connection between the electrodes.
Fig. 6 shows a cross section of two transducers in accordance with embodiments of the present invention, including lateral stress release cuts in the piezoelectric layer provided on a flexible layer. Electrodes are provided to collect charges generated in the piezoelectric layer. The top transducer includes electrodes at the bottom of the gap and a counter electrode at the opposite surface of the piezoelectric layer, sandwiched by the piezoelectric layer and the flexible layer. The bottom transducer shows an electrode at the bottom of the gap and extending underneath the magnetic structures.
Fig. 7 shows, on the left, a beam structure, forming a rhombus, and on the right, the top view of a passive magneto-electric transducer transducer in accordance with embodiments of the present invention, fabricated with these structures as amplification structures to enhance the strain response of the piezoelectric layer.
Fig. 8 shows a graph of the input-related noise as a function of the frequency, comparing the behavior of the device of the present invention with existing devices.
Fig. 9 shows a cross-sectional view of a transducer in accordance with embodiments of the present invention.
Fig. 10 shows on the left a top view, and on the right a cross-section, of a transducer in accordance with embodiments of the present invention. The electrodes, e.g. all the electrodes, are provided on the surface of the substrate being in contact with the piezoelectric layer.
Fig. 11 shows a staggered 2D array of magnetic structures for a transducer in accordance with embodiments of the present invention.
Fig. 12 shows an array of electrodes corresponding to the array of Fig. 11
Fig. 13 shows the relationship between saturation flux density of the material and the energy output for different materials of a magnetic structure.
Fig. 14 and Fig. 15 show two steps of a transducer manufacturing method in accordance with embodiments of the present invention.
Fig. 16 and Fig. 17 show two alternative embodiments of a transducer in accordance with embodiments of the present invention, including a cavity underneath the piezoelectric layer. Fig. 16 includes cuts in the piezoelectric layer that open to the cavity, while Fig. 17 includes a membrane over the supporting structures, which hold the piezoelectric layer and electrodes. Cuts through the piezoelectric layer in Fig. 17 stop at that membrane.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The following terms are provided solely to aid in the understanding of the invention.

As used herein, and unless otherwise specified, the term "transducer" refers to a device that converts energy from one form to another, such as converting mechanical energy into electrical energy or vice versa. Examples of transducers include piezoelectric transducers, magnetoelectric transducers, and passive magnetoelectric transducers that generate a signal without external electrical power sources.

As used herein, and unless otherwise specified, the term "piezoelectric layer" refers to a layer of material that exhibits the piezoelectric effect, which is the ability to generate an electric charge in response to applied mechanical stress or strain. Examples of piezoelectric materials include aluminum nitride, aluminum scandium nitride, zinc oxide, lead zirconium titanate, etc.

As used herein, and unless otherwise specified, the term "magnetic structures" refers to elements or components made of high permeability magnetic materials that are attached to the piezoelectric layer and are shaped and positioned to generate strain on the piezoelectric layer when subjected to an external magnetic field. Examples of magnetic structures include pairs of magnetic elements made from materials such as Ni, Fe, Co, or combinations thereof. These materials, for example Co, can be used to increase the magnetization saturation thereby increasing the range of the sensor.

With high permeability is understood as the permeability where the material does not restrict the operation. For example, a high permeability may be larger than the saturation magnetization divided by the switch field (Mₛₐₜ/ H_{switch}). Since µ₀ · Mₛₐₜ is typically 1000 mT and µ₀ · H_{switch} is typically lower than 20 mT, the permeability may be higher than 50, for example higher than 500, for example higher than 1000.

As used herein, and unless otherwise specified, the term "electrodes" refers to conductive elements positioned adjacent, or in contact with, the piezoelectric layer to collect charges generated by the piezoelectric layer in response to mechanical strain. Examples of electrode materials include highly conductive materials, such as metals like Pt, Au, W, Mo, Cu and other metals and alloys thereof.

As used herein, and unless otherwise specified, the term "lateral stress release cuts" refers to cuts or openings made in the piezoelectric layer to increase its flexibility by allowing for lateral stress relief. Examples of lateral stress release cuts include slits, slots, or gaps in the piezoelectric layer.

As used herein, and unless otherwise specified, the term "flexible layer" refers to a layer of material that provides mechanical decoupling between the piezoelectric layer and a rigid substrate. Examples of flexible layer materials include elastic polyimide. A flexible layer may comprise structures adapted to be flexible, for example thin cantilevers etched from rigid materials, for example made of semiconductor materials, e.g. of a silicon membrane.

As used herein, and unless otherwise specified, the term "out-of-plane strain" refers to a strain or deformation of the piezoelectric layer in a direction perpendicular to its plane. Analogously "in-plane strain" refers to a strain parallel to the plane of the piezoelectric layer. The in-plane strain difference may result in out-of-plane deformation of the piezoelectric layer, e.g. bending or warping. These strains in embodiments of the present invention are caused by forces, or force pairs, generated between magnetic structures when subjected to an external magnetic field.

The present invention relates to a transducer wherein soft-magnetic pieces are mechanically attached to an underlying piezoelectrical material. The pieces are arranged so that when they are magnetized by an external magnetic field, a force or force pair is generated on each magnetic piece. In other words, the pieces attract each other resulting in a stress in the underlying piezoelectrical material.

More in detail, the present invention provides a transducer comprising at least two structures, e.g. an array of magnetic structures that are placed directly on a piezoelectric layer. The magnetic structures are placed in such a way that there is an interaction, e.g. an attractive interaction, between them, e.g. between pairs of structures in the array, when a magnetic field is present. The orientation and disposition of the magnetic structures may be adapted to take the direction of the magnetic field into account in the output of the device, so the output is more sensitive for predetermined orientation of the magnetic field. For example, the pieces are elongated or the distance between them is relatively small in a certain direction than in others, the transducer will show higher sensitivity in said direction. The presence of an appropriate magnetic field causes, for example, a pull towards each other. An array of structures is arranged in such a way that the mechanical forces created by an applied magnetic field are maximized when these structures pull towards each other, due to the magnetic force between the structures.

Depending on the distribution of the magnetic pieces or structures, the stresses or forces are transferred to the piezoelectrical material in different ways. For example, it may cause an out-of-plane strain in the piezoelectric material indirectly, via in-plane stresses. This out-of-plane strain causes a change in the out-of-plane polarization of the piezoelectrical material. Related to this polarization change, a differential charge occurs on the piezoelectric material's top and bottom. These charges can be collected by electrodes. When the electrodes are connected to a high-ohmic external circuit or are left unconnected, a potential difference occurs on these electrodes. Alternatively, the out-of-plane strain may be generated directly by out-of-plane stress, e.g. by a torque caused by in-plane forces on magnetic structures attached to the piezoelectric layer. Due to the torque, a part of the elongated structure presses on a part of the surface of the piezoelectric layer to which the structure is attached, while a different part of the structure pulls on a different part of the surface of the piezoelectric layer. In such case, the charges may be generated at different areas of the layer.

At least two electrodes, e.g. an array of electrodes, may collect the charges generated due to e.g. the forces on the piezoelectric layer by the structures in the array thereof.

It is an advantage of embodiments of the present invention that passive magneto-electric transducer can be provided, which efficiently and reliably generates electrical signals from magnetic fields without the need for external power sources.

More in detail, for some embodiments, the magnetic field creates an in-plane compressive stress in the piezoelectric layer between the magnetic structures that are pulled together. An in-plane tensile stress is created between magnetic structures that are pushed apart. The compressive stress will create a charge of a first sign at the bottom of the piezoelectric layer between the magnetic structures that are pulled together, and a charge of the opposite sign at the bottom of the piezoelectric layer between the magnetic structures, that are pulled apart. The sign of the charge depends on many factors, such as e.g. the orientation of the piezoelectrical layer. Wurtzite crystals, like AIN or ZnO, create a negative charge on their top surface under tensile in-plane stress, when the c-axis of the crystal points away from the substrate. Different orientation configurations may be possible depending on the process and material; for example, in the figures, the c-axis points down towards the so-called nitrogen polar surface of the substrate (e.g. the AIN of the nitrogen polar surface side etches much faster than from the Al polar side). Using a lift-off process, it is possible to deposit on the c-axis pointing away from the substrate (Al polar surface up).

Electrodes are provided at the bottom of the piezoelectric layer distributed in the predetermined regions where the charges are generated, to collect these charges. Thus, for example, electrodes between converging structures become negatively charged and electrodes between diverging structures become positively charged, if they are placed at the bottom of the piezoelectric layer and oppositely charged if they are placed on top.

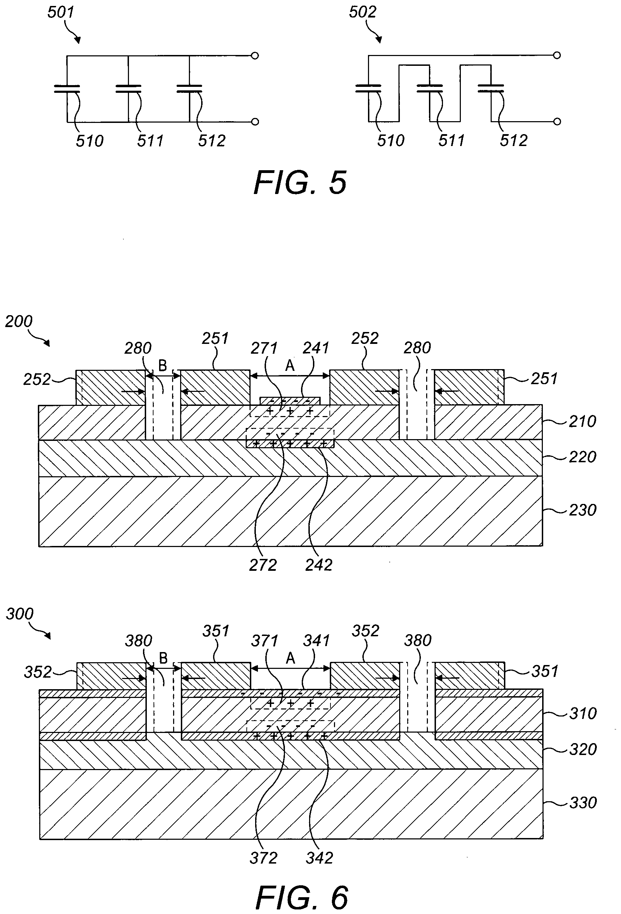

The electrodes may be interconnected in different ways, to increase the collected charge or to increase the voltage at the output nodes. For example, a configuration wherein those electrodes adapted to receive charges of the same sign are interconnected (thus obtaining a set of interconnected positive electrodes, and a set of interconnected negative electrodes) to increase the collected charge, see left arrangement 501 of FIG. 5. Alternatively, an electrode adapted to receive charges of a first sign of a pair can be connected to the electrode of opposite sign of a different pair, so different pairs are connected in series to increase the voltage at the output nodes, see right arrangement 502 of FIG. 5. The transducer can be used as a sensor, thus providing a signal sensitive to the strength of the applied field, or as a magnetic switch, thus switching the output between two states (e.g. ON and OFF) when the magnetic field surpasses a predetermined threshold.

The present invention allows control of a switching transistor, for example, which allows closing it with no need of external power, just by the influence of the external field causing the switching. With the new solution, a switch in accordance with embodiments of the present invention does not rely on mechanical contact features, which are inherently prone to degradation upon switching, particularly if there is current flowing through the contact upon switching. The present invention allows forming contact by a MOSFET structure. A lifetime with a factor 10⁹ better is expected. This improved lifetime enables other applications like safety applications and higher frequency operations wherein a lot of switching is expected.

There is only very little change expected versus temperature. The force exerted by the structure is mainly defined by the shape of the structure. The change of the piezoelectrical constant of piezoelectric materials (such as AIN) with temperature is negligible. The amount of charge that is thus generated by the magnetic front end by a certain exposure to magnetic field is almost constant over temperature. If this front end is combined with a high-temperature-resistant MOSFET, high operating temperature can be achieved.

Next to the higher reliability, switch speeds are expected to be about 1000 to 10000 times higher than existing switches, thus reducing reaction times typically of 1 ms to less than a 1 microsecond. This could enlarge the scope of the applications where the switches can be used, including fast moving robotic alignment, quick safety stops, etc.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

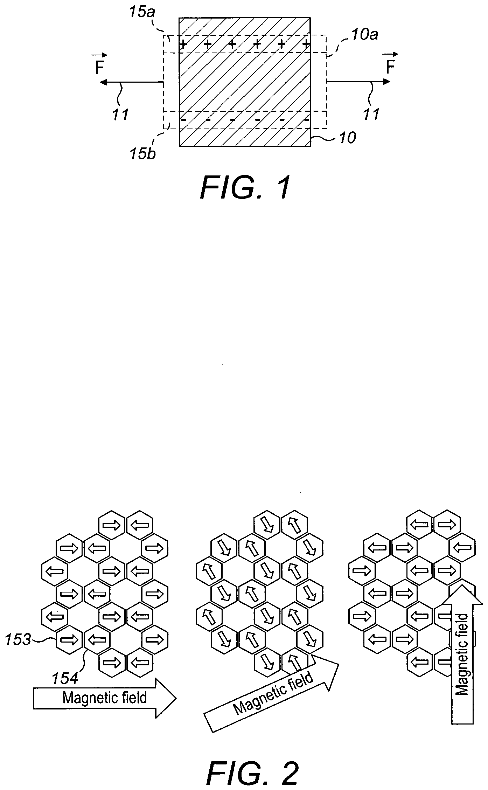

Fig. 1 shows a layer of piezoelectric material 10 at rest and when it is laterally stretched 10a. The figure shows the force vectors (F) 11 causing the stretching of the piezoelectric material. The stretching force generates an electric potential between the top region 15a and bottom region 15b of the piezoelectric material, by collecting positive charges on the top part 15a and negative charges on the bottom part 15b of the layer 10a.

Fig. 2 shows a layout of an array of magnetic structures, configured to generate a force on the anchoring surface of the piezoelectric layer when a magnetic field is applied in a given direction.

A set of lines of magnetic structures 153, 154 are placed in a staggered way, meaning that there is an offset between the two lines of magnetic structures. By placing the structures in such a way, the magnetic flux lines will lace through the magnetic structures, alternating between structures from the two different lines. The magnetic flux lines are entering and leaving the magnetic structures from the same side, the side in vicinity of the other line of magnetic structures. To reduce the length of the magnetic flux lines in the air, the structures are attracted towards each other. The layout of sets of magnetic structures that attract each other is optimized in such a way that a maximum force (or force pair) can be generated between adjacent structures, irrespective of the sign of the magnetic field. This is mainly achieved by the relative position, and also the size and the gap between attracting magnetic structures, by making high structures and/or by using material with high magnetic saturation levels.

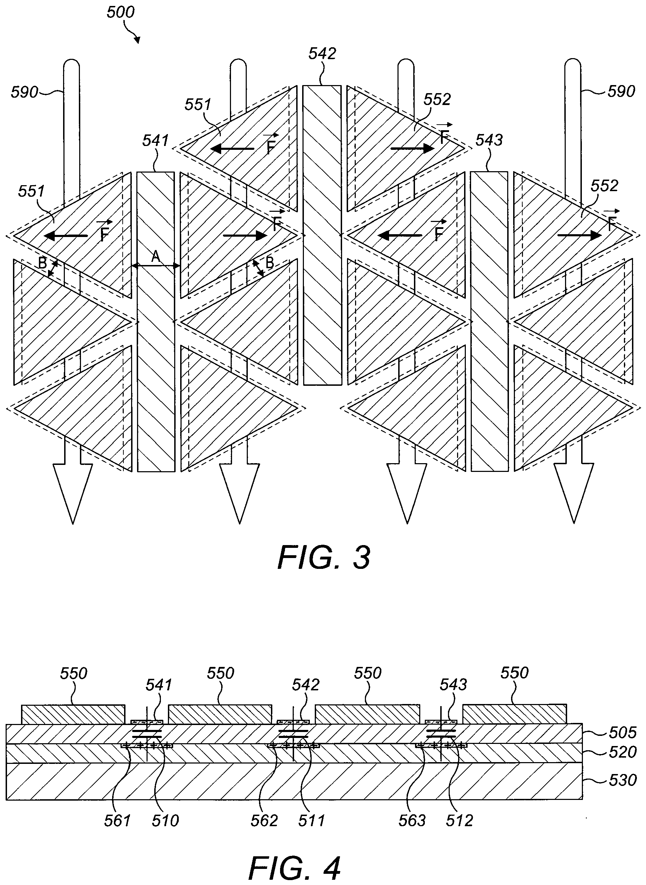

Fig. 3 shows a top view of an arrangement of triangular magnetic structures 551, 552 aligned at each side of an electrode 541, 542, 543. The triangles at each side of the electrode are arranged with a side or vertex facing the same respective side or vertex of the opposite triangle. The magnetic structures 551, 552 are provided on the piezoelectric layer defining gaps (A) between repelling structures and gaps (B) between attracting structures. The triangles along the stripe sequentially change orientation, so if the first opposite triangles are arranged with a side towards the electrode, the second opposite triangles along the stripe are arranged with the side facing away the electrodes. The magnetic flux planar to the surface, shown as (B) 590, causes the different force pairs on triangles at opposite sides of the electrodes.

Fig. 4 shows a cross section, with magnetic structures 550 on a piezoelectric layer 505 on a flexible layer 520 supported by a substrate 530, e.g. a semiconductor substrate which may optionally include electronics, e.g. a CMOS substrate e.g. a silicon substrate, which can advantageously comprise integrated electronics, e.g. provided by CMOS processing. The present invention is not limited to semiconductor substrates, and other substrates could be used, such as glass, sapphire, PCB, FR4, etc. The piezoelectrical layer 505 will convert the stresses that arise from the magnetic structures 550 into a voltage. In other words, the stresses caused by the attraction of the magnetic structures 550 will create electrical fields in the piezoelectric layer. These electric fields inside the piezoelectric layer 550 generate an electric potential difference at opposite sides of piezoelectric layer, which is picked up by electrodes 561, 562, 563 provided at the bottom of the piezoelectric layer, and electrodes 541, 542, 543 provided at the top. In other words, due to the attraction of pairs of magnetic structures, a tensile stress acts between the structures, and the piezoelectric layer to which the structures are attached is submitted to a shear stress. Since it is fixed to an underlaying flexible layer, a potential is generated across the thickness of the piezoelectric layer. Thus, the piezoelectric layer behaves as a capacitor. As shown in Fig. 5, the capacitor 510, is formed with corresponding electrodes 541, 561 between the same pair of magnetic elements. By connecting electrodes of similar structures in parallel, the collected charge can be increased. Such groups of interconnected electrodes 510, 511, 512 can also be put in series to increase the generated voltage.

The electrodes can be connected to the substrate via any suitable means, e.g. they can be connected to metallic pads on the substrate through vias in the polyimide layer via sputtered layers, electroplated layers, or wire bonds.

To increase the stress on the piezoelectric layer and thus the energy that can be picked up by the piezoelectric layer, some cuts can be provided in the piezoelectric layer and potentially even deeper in narrow gaps where the magnetic structures are very closely spaced. If there are stiff structures in these regions, the displacement of the magnetic structures is severely obstructed, minimizing the mechanical energy that can be extracted upon magnetization. Fig. 6 shows a cross section of two transducers including such lateral stress release cuts 280, 380 in the piezoelectric layer 210, 310 between attracting magnetic structures 251, 252, 351, 352. The piezoelectric layer is provided on a flexible layer 220, 320 on a device substrate 230, 330. Electrodes 241, 242, 341, 342 are provided to collect charges 271, 272, 371, 372 generated in the piezoelectric layer. The transducer 200 on top includes electrodes at the bottom of the gap and a counter electrode at the opposite surface of the piezoelectric layer 310, sandwiched by the piezoelectric layer 310 and the flexible layer 220. The transducer 300 on the bottom shows an electrode 341 at the bottom of the gap and extending underneath the magnetic structures 351, 352. Thus, the magnetic structures may be provided mechanically attached to the piezoelectric layer, either directly, or over the top electrode 341, the top electrode 341 being also provided on the piezoelectric layer 310. In some embodiments, a layer of adhesive material can be used to attach the magnetic structures. For example, the flexible layer 320 can be laminated to the substrate (e.g. wafer) such as Die Adhesive Foil (DAF). Photosensitive polyimide can be used. For example, the soft magnetic layer can be glued to the top of the piezoelectric layer. For example, a preformed soft magnetic layer can be glued, or the layer may be formed after gluing a full strip.

Analogously, the flexible layer 320 may be attached to electrodes 342 which are in turn provided on top of, and attached to, the piezoelectric layer 310, so there is no direct contact between the piezoelectric layer and the flexible layer as shown in Fig. 6.

A further way to increase the flexibility of the magnetic pieces and to increase the stresses on the piezoelectric layer is by introducing mechanical amplification structures, which convert a low force, a high displacement into a high force and a low displacement. These structures improve energy conversion efficiency by mechanical impedance matching.

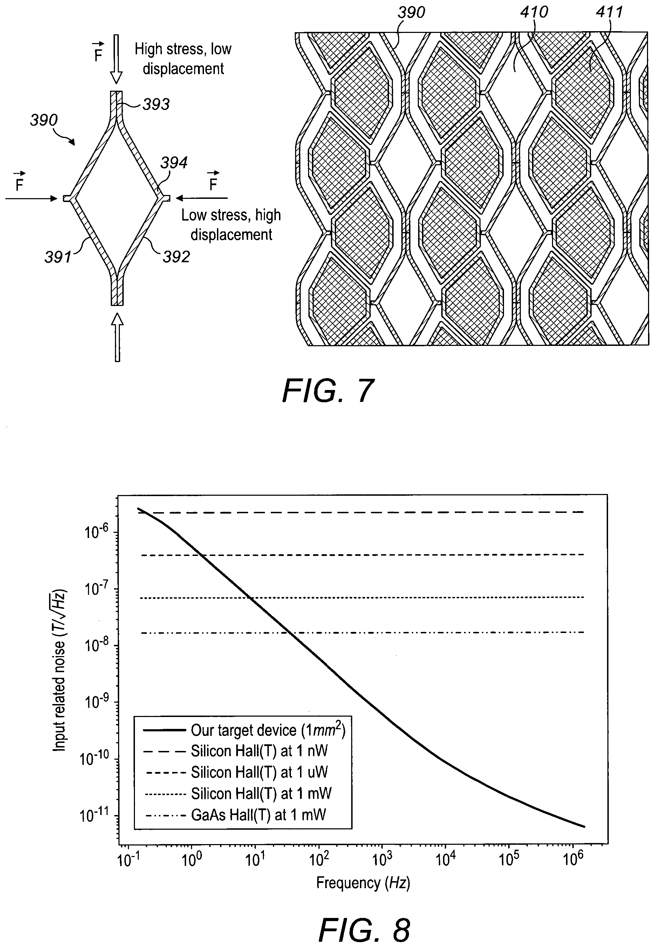

Fig. 7, on the left, shows the beam structure 390 made by two shaped beams 391, 392 that join at the longitudinal opposite sides, forming a rhombus. The connecting beams are kept slender in order to increase the stress and the voltage to the maximum. The beams may comprise a layer stack, with a layer of piezoelectric material between a first layer of electrode material and a second layer of electrode material, thus including the piezoelectric layer. The width may be between 10 and 20 microns. The beams are surrounded by stress relief cuts. An in-plane force F applied at the beam attachment region, on the acute angles 393, generates a low displacement at that point but a high displacement at the point of the obtuse angles 394, which can be compensated by a low force at these obtuse angles. An in-plane force F applied in the direction of the short axis of the rhombus, along the obtuse angles 394, will create a high displacement at these points while creating a low displacement at the acute angles 393, needing a high force on these acute angles to compensate the stress at the obtuse angles. A low force, high displacement input from a magnetic field can be transferred to a high stress, low strain at the piezoelectric layer, allowing a high signal representative of the magnetic field.

Fig. 7, on the right, is the top view of a passive magneto-electric transducer fabricated with chevron-type mechanical amplification structures 390 to enhance the strain response of the piezoelectric layer, when force pairs are generated by magnetic structures 411. Stress release cuts 410 can be added.

The embodiments described above comprise a flexible layer including flexible material. The main function of the flexible layer is to attach the structures to the substrate while creating as little restriction as possible to the lateral movement, allowing the piezoelectric layer to deform as much as possible when the magnetic structures on top exercise a force. The deformation of the piezoelectric layer changes its polarization thereby producing the desired charge. However, the attachment to the surface can also be obtained by different methods, which minimally restrict the lateral movement. For example, the magnetic structures can be placed on beam structures, which are attached to the substrate, with the piezoelectric layer connecting those beam structures. In such a way the lateral movement is not hindered, everything is attached to the substrate and all the forces are concentrated in the piezoelectric layer.

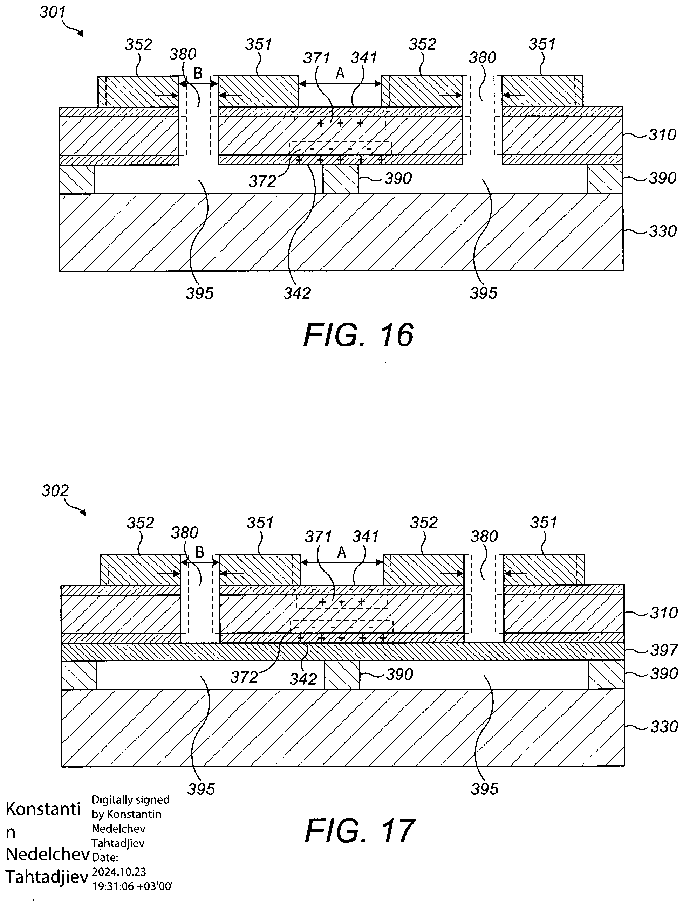

Fig. 16 shows an alternative embodiment similar to the embodiment of Fig. 6, without flexible material below the electrodes. The transducer 301 includes a substrate 330 which holds a layer 310 of piezoelectric material. The layer is divided by several gaps 380. The layer 310 is sandwiched between two electrodes 341, 342 at top and bottom. The top electrode includes two magnetic structures 351, 352 which are arranged to repel each other by an applied magnetic field. The arrows indicate that one of the magnetic structures 351 is pulled to the left by magnetic field, and that the other structure 352 is pulled to the right, both structures being on top of the same electrode 341. A gap A is provided between repelling magnetic structures, as indicated by the arrows. The gap 380 through the piezoelectric layer opens to a gap B between attracting magnetic structures separated by said gap B. Thus, repelling structures over the same electrode are separated by a first gap A, while attracting structures over different adjacent electrodes are separated by a second gap B which extends through the piezoelectric material.

This is similar to Fig. 6, however Fig. 16 shows that, instead of a flexible layer, a cavity 395 is provided between the bottom electrode 342 and the substrate 330. Mechanical support structures 390 which support the electrodes and piezoelectric layer. In some embodiments the structures may comprise cantilevers. The cavity 395 provides the flexibility required to let the piezoelectric layer deform when a magnetic field attracts the magnetic structures 351, 352. The structures 390 are stiff, but very narrow, so they can hold the layer stack on top of them while allowing deformation of the piezoelectric layer, for example allowing a large degree of lateral motion. The deformation of the piezoelectric layer generates charge 371 in piezoelectric layer near (higher) electrode 341, and charge 372 in piezoelectric layer near (lower) electrode 342, and the electrodes accept said charges. The positioning of the support structures 390 allows a large concentration of charges near the support structures. Since the support structures only clamp the piezoelectric layer in a relatively small area due to the narrow shape of these structures, the rest of the layer can contribute to charge generation. Since no flexible layer is required, the piezoelectric layer can be processed at high temperatures, allowing the deposition of lead zirconium titanate.

Fig. 17 discloses a similar structure as Fig. 16, with a membrane layer 397 between the structures 390, and the electrodes 342 and piezoelectric layer 310. The membrane layer 397 improves the mechanical stability and sturdiness of the transducer. The membrane layer can be sized with a thickness between 10 nm and 5000 nm so that it does not reduce significantly the deformation of the piezoelectric layer. The gaps B extending through the piezoelectric layer do not extend through the membrane. Stiff mechanical supports 390 hold the membrane and the layer stacks over the cavity 395.

There are many ways to provide membranes under the piezo-electric layer.

In one embodiment, the substrate 330, mechanical substrates 390 and membrane 397 are all provided by silicon, e.g. bonding a silicon wafer with cavities onto another silicon wafer, and then thin the second silicon wafer.

In another embodiment, a SOI wafer can be used with Deep Trench Isolation made of (e.g. comprising) oxide, and then etch away all the oxide. This keeps the silicon as the main bending material.

Cavities can also made inside the metal stack of a CMOS wafer Metal and vias can be structured in such a way that cavities can be etched with vapor HF where the oxide in the stack is etched and the etching is blocked by metal at the bottom, top and at the sides.

Again another way is to pattern the polyimide after deposition. One could illuminate a photosensitive polyimide before the deposition of the piezoelectric and magnetic layers and develop and cure the polyimide as last step. An additional protection layer may be used to protect the uncured polyimide from influences from the processing such as other formations of photoresist layer or generation of light including UV light during plasma processes.

The transducer can be used, as pointed out earlier, as a switch or as a sensor. The transducer can act as a front-end, wherein the interconnections between electrodes are provided in a back-end, so that different configurations of the back-end can provide different configurations of the device as sensor or switch, while using the same front-end.

To create a switch out of the described magnetic sensor front-end, it is suitably connected to a transistor. The voltage/ charge picked up by the electrodes is transferred to a transistor with a very high gate isolation, e.g. CMOS, IGBT,.... This transistor will then be switched to create a channel. The transistor may be provided on the substrate, for example, with one electrode connected to the gate and the other to the source, for example.

To create a magnetic sensor, the device can be connected directly to a buffer amplifier and an ADC. Fig. 8 shows a graph of the input-related noise (T/(square root Hz)) as a function of the frequency (Hz). The graph shows for a 1 mm² of the present device, the signal to noise ratio (full line) is better than for conventional devices (dotted lines, from top to bottom: silicon Hall at 1nW, at 1 µW, and at 1mW, and GaAs Hall at 1mW) at high frequencies. The SNR is higher for Hall plates that dissipate low power, which happens in Hall plates that do not use a high power.

In the following, two different mechanisms of charge generation are illustrated with reference to two embodiments.

Considering a pair of soft magnetic structures, or lines of staggered soft magnetic structures, when applying a magnetic field, the magnetic field lines will follow the path of least resistance. Thus, they tend to zigzag through the magnetic structures minimizing the transit through the airgaps, exerting a force on the staggered magnetic pieces and pulling them together, tending to close the airgap in order to minimize the available magnetic energy. This attractive force on the soft-magnetic pieces exerts a force on the place of attachment, transferring it to the underlying piezoelectric layer.

Depending on the shape and disposition of the magnetic structures, and the freedom of motion of the piezoelectric layer, the piezoelectric layer generates charges of one sign on a predetermined region and charges of a different sign on a different region. In some embodiments, the piezoelectric layer may have its active axis out of plane, so a charge displacement will happen from the top to the bottom of the piezoelectric layer. The active axis may be perpendicular to the substrate, which is advantageously easy to manufacture.

If the piezoelectric layer is provided on a flexible layer, such as cantilevers or a layer of flexible material, the magnetic structures experience a (e.g. attractive) force between them, and charges of one sign will tend to accumulate under the compressed region in the gap, while charges of opposite sign tend to accumulate under extended areas (or splayed or pulled areas), at the surface of the piezoelectric layer opposite to the surface including the magnetic structures. On the other hand, if the piezoelectric layer is fixed to a rigid substrate, so that the lower surface cannot strain, the magnetic structures can be arranged so that they experience a torque, which will also deform the piezoelectric layer. It will compress the piezoelectric layer under one side of the magnetic structure while at the opposite side of the magnetic structure the piezoelectric layer will be stretched.

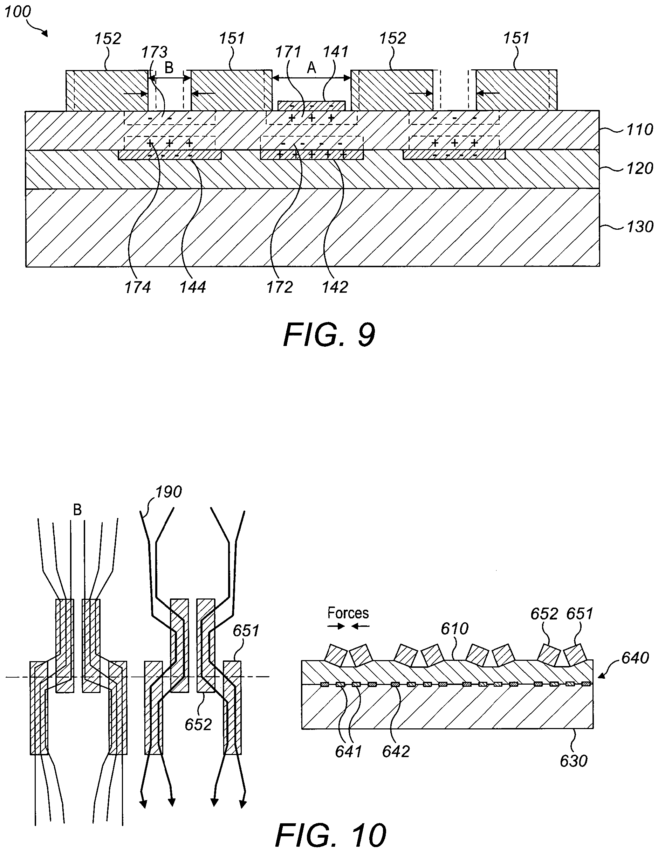

Fig. 9 shows a cross-sectional view of a transducer 100 comprising a piezoelectric layer 110 on a flexible layer 120 formed on a device substrate 130, such as a CMOS substrate. Magnetic structures 151, 152 are provided on top of the surface of the piezoelectric layer. They are mechanically connected thereto.

By having the flexible layer 120 below the piezoelectric layer, the stress caused by the movement of the high permeability structures 151,152 is confined in the piezoelectric layer. Gaps are defined between the different structures. The gaps between neighboring structures do not need to be the same size.

The pair of high permeability structures 151, 152 is designed such a way that when a magnetic field goes through the structures 151, 152 perpendicular to the plane defined by Fig. 9, the magnetic attraction pulls the structures 151 and 152 together (the pair formed by the two leftmost structures), and thereby closes the gap B between them. This movement creates a force, which causes stress on the piezoelectric layer and results in a potential difference between the top and bottom regions of the piezoelectric layer 110, as described in Fig. 1. The material for the structures 151, 152 may be any high permeability material that is suitable for integration, for example, NiFe.

To make the potential difference larger and more easily detectable, it is possible to implement more similar pairs of high permeability structures e.g. as shown in Fig. 9, where a second pair is implemented at a distance from the first pair. It is also possible to extend the device into a 2D structure. This creates several charged regions 171-174 on the surface of the piezoelectric layer 110. These regions are therefore suitable for reading out the potential difference with electrodes 142, and 144 at the bottom of the piezoelectric layer, while the electrode 141 on top is shorting regions 171 and 173 between the respective structures. Thus, the electrodes 141, 142, and 144 are provided to collect charges 171, 172, 173, and 174 generated in the different regions of the piezoelectric layer. Those regions on top of this piezoelectric layer which compress generate charges of one sign, and opposite charges on the regions which undergo extension.

The embodiments of Fig. 3, 4, 6, 7, 9, 16, and 17 show that the out-of-plane strain is generated indirectly by in-plane stresses. Via the Poisson coefficient, the in-plane stress is converted into out-of-plane strain. To augment the stress to the maximum possible, it is important to concentrate the arising stress as much as possible in the piezoelectric layer. For example, the piezoelectric layer may be decoupled mechanically from the substrate, by e.g. a flexible layer or the like. Hence, extension or compression in different regions of the piezoelectric layer is generated by the interaction of the magnetic structures, and facilitated by the flexible layer.

However, the present invention is not limited thereto. The out-of-plane strain can also be generated directly by out-of-plane stress. This out-of-plane stress can be generated by torque generated on magnetic structures from in-plane forces on the magnetic structures, due to the interaction with the external magnetic field.

More in detail, Fig. 10 shows (on the left) a top view, and (on the right) a cross-section, of a transducer in accordance with embodiments of the present invention. The cross-section on the right shows a rigid substrate 630 and a piezoelectric layer 610 sandwiching the respective electrodes 641, 642. For example, the electrodes may be provided on a metallization layer 640 on the surface of the substrate 630 being in contact with the piezoelectric layer 610. The substrate 630 may be e.g. a semiconductor substrate. The piezoelectric layer 610 may be provided and fixedly attached to the substrate 630, without an intermediate flexible layer. On top of the piezoelectric layer, the magnetic structures 651, 652 are provided as before.

The top view shows that the magnetic structures are elongated, and the structures stagger with respect to each other. Thus, the magnetic field lines 190 (which in this case are parallel to the direction of the magnetic structures) enter and exit the material of the magnetic structure 161 through one side into another magnetic structure 162, pulling the whole magnetic structure to this side.

Because of the lateral force arising between the magnetized pieces, each magnetic piece undergoes a torque, shown in the cross-section. This causes a differential force on the surface of the piezoelectric layer 630 where the magnetic structures are mechanically attached. This causes a differential polarization in the underlying piezoelectric material 630. Since the top surface is shorted locally by the magnetic structures or by another metallic layer, there is a potential difference at the bottom surface between two regions, one region underneath the area where a structure generates compression on the piezoelectric layer due to the torque, and another region underneath the area where the structure generates tensile strain on the piezoelectric layer. At these regions, the two sets of electrodes 641, 642 can be positioned. The electrodes of one set 641 collect charges of a given sign, while electrodes 642 of the other set collect charges of the opposite sign. Thus, due to magnetic interactions between magnetic structures, stress is generated on the piezoelectric layer which is converted to charges at different positions of the layer, wherein the charges are collected by electrodes. Different connections between these electrodes provide different behaviors and benefits, such as sensing or switching.

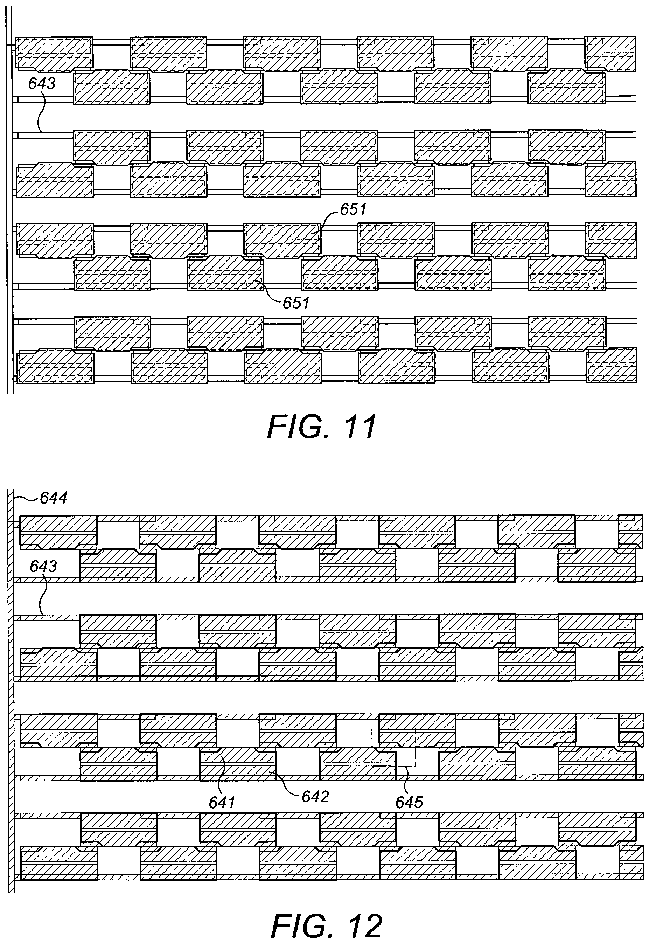

In general, the layout of the array of magnetic structures is optimized in such a way that the magnetic force is maximized when a field is applied to the array. For example, the basic structure shown in Fig. 10 can be expanded into an array. Such staggered 2D array of magnetic structures 651, 652 is shown in FIG. 11. Also, underlying electrode connections 643 are shown, however, it is noted that the electrode connections and the structures are separated by the piezoelectric layer. The structures are positioned over the piezoelectric layer, and they are arranged in four sets of staggered structures, so that a portion (approximately the width) of the structure faces a corresponding portion of another structure, leaving a gap between the structures. The magnetic field traverses these gaps (air gaps) between the structures, following the path of least resistance. This generates torque on the magnetic structures, and the related stresses below the magnetic structures, causing strains on the piezoelectric layer, thus generating charges as explained above.

A corresponding array of electrodes 641, 642 is shown in Fig. 12. The electrodes are arranged in sets. Each magnetic structure 652 overlaps two electrodes 641, 642. The figure shows all electrodes 642 of the same set connected to each other via electrode 643, all being connected in parallel and a line 644 on one edge of the array, for e.g. connection with an output stage or the like. The electrodes 641 of the other set are also interconnected to a line, at the other side of the array (not pictured). The electrodes 641 in Fig. 10 are all connected together, in particular the part marked with a dotted rectangle 645. Since the electrodes 641, 642 of each set are separated by a distance and no conductive connection is provided between them, a capacitive coupling is obtained between electrodes even if laid out side by side, much like the electrodes in Fig. 4 act as effective capacitors since they are separated by the thickness of the piezoelectric layer, wherein the role of dielectric of the capacitor is fulfilled by the material of the piezoelectric layer. The effective capacitance between these electrodes 641 and 642 can be increased by providing a conductive layer at the topside of the piezoelectric layer. The array of electrodes in Fig. 12 is connected so that the electrode array behaves as a set of capacitors connected in parallel, in the arrangement 501 in parallel shown on the left side of Fig. 5. Thus, an electrode accepting charges of a sign in one pair can be connected to an electrode accepting charges of a different sign in another pair, or alternatively, the electrodes of different pairs arranged to accept charges of the same sign can be connected to each other, depending on whether an increase of charge or voltage is required.

The device may comprise a connection for connecting one or more electrodes to a further device. In some embodiments the device may be an output stage for providing a sensing signal representative of the field through the device, thus providing a sensor. In some embodiments the device may be a transistor, for opening or closing the transistor. In some embodiments, the electrodes can be advantageously connected in series or in parallel to provide to the further device a charge or a voltage, depending on the required signal. For example, it may be in parallel for providing charge to e.g. open a transistor. They may be connected in series, if the output stage requires a voltage to provide the signal readout.

In a further aspect, the present invention provides a method of manufacturing the transducer of embodiments of the present invention.

The method comprises providing a piezoelectric layer, providing soft magnetic structures on the surface of the piezoelectric layer, and providing electrodes for contacting the piezoelectric layer, which are distributed according to the position of the magnetic structures. These layers can be supported by a substrate, placed facing the surface of the piezoelectric layer opposite to the surface with the magnetic structures. The substrate may be a substrate containing electronics, e.g. semiconductor substrate or the like, including connections and such for the electrodes, the present invention not being limited thereto. The method comprises optionally providing a flexible layer for supporting the piezoelectric layer, on the surface opposite to the magnetic structures, sandwiched between the piezoelectric layer and the substrate. The substrate may comprise the electrodes, which may be then optionally covered by the flexible layer, and/or covered by the piezoelectric layer, to which the magnetic structures may be placed. The present invention is not limited thereto.

In some embodiments of the method, in a first step, a flexible layer is provided on the substrate. Providing the flexible layer may comprise spinning a polyimide coating on top of a substrate. As an alternative for spin coating one can also laminate polymers on wafers, by 'dry film resist' procedures. These methods are advantageously easy to apply.

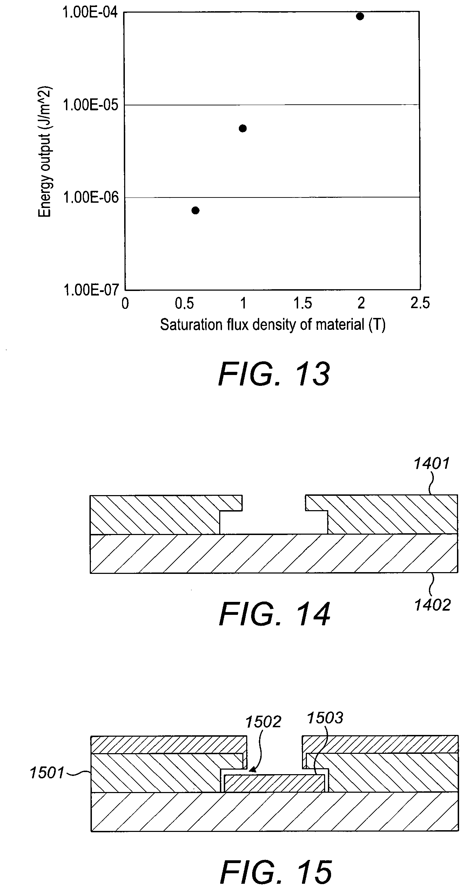

Then, a photoresist mask 1401 is deposited and patterned on a substrate 1402, e.g. a wafer, as shown in Fig. 14 showing a lift-off process wherein the substrate 1402 already contains the polyimide layer.

Afterwards, the bottom electrode layer is provided, for example by sputtering a metal layer, e.g. platinum layer, through the lift-off mask. In some embodiments, this mask includes an undercut, so there is a gap 1502 between the photoresist mask 1501 and the platinum 1504, to facilitate the dissolution of the photoresist layer after the platinum deposition. This is shown in Fig. 15. In some embodiments, a chromium or titanium adhesion layer is deposited before the platinum, so the adhesion of the platinum improves.

Other methods can be applied, for example, it is possible to deposit a layer comprising platinum (for example a blanket of platinum) and then to etch (for example, by ion milling) part of the platinum through a photoresist layer.

In a next step, a piezoelectric layer, e.g. a thin aluminum nitride layer, is provided, for example by sputtering, e.g. on the flexible layer. The thickness of this layer may be between 50 nm and 10 µm, e.g. between 200 nm and 2 µm. The layer may include gaps. For example, the piezoelectric layer may be sputtered through a lift-off mask, to provide gaps in the piezoelectric layer, to facilitate movement and to have access to the bottom electrode layer. Through the same lift-off mask, the top electrode layer can be provided, e.g. also by sputtering. This top electrode may comprise copper with chromium as adhesion layer.

If the top and the bottom electrode layer need to be interconnected, the top electrode layer can also be sputtered after removing the AIN lift-off mask. Another mask can be provided later to pattern the top electrode layer and optionally also other interconnection lines.

Then a photoresist layer (for example, 30 µm thick) is deposited. In some embodiments, it may be a negative photoresist, which can be illuminated and developed to form a resist pattern with very steep side walls and narrow cavities and walls. In some embodiments, the aspect ratio, depth versus wall width ratio, can be more than 10. In some embodiments, this layer is a patterned positive photoresist, where the illuminated area dissolves faster, and it is much easier to strip than a negative photoresist.

With the photoresist as mold, and the second layer as top electrode, a structure of soft magnetic material is provided, e.g. electroplated. The thickness may be at least 5 µm for example around 25 microns. The thicker, the higher the potential signal, however, this signal is only generated at a higher magnetic field. The material of the magnetic structure may comprise Ni, Fe, Co, other soft magnetic materials, a combination of them. The magnetic saturation of the material is adapted to generate high forces when submitted to magnetic fields, thus the preferred material is FeCo in some embodiments of the present invention. Fig. 13 shows the relationship between saturation flux density of the material and the energy output. The data points correspond, from left to right, to Ni/ NiFe/ CoFe.

It is noted that the thicker the layer can grow, the higher the force on the piezoelectric material would be. The maximal force on the soft magnetic material scales linearly with the height.

After electroplating the magnetic layer, the photoresist is stripped in acetone.

Oxygen-reactive ion etching is used to make cuts in the polyimide base layer and to remove any photoresist remnants.

The combination of the polymer-backed piezoelectric layer and plated magnetic structures enables the fabrication of highly sensitive, flexible, and customizable passive magnetoelectric transducers. This approach opens up new possibilities for integrating these devices into wearable electronics, soft robotics, and flexible sensor arrays. Since mechanically formed contacts are not required, a reliable device is obtained. The device is also highly compact, and it is modular since a front-end including the magnetic structures and electrodes can be combined with a lot of different back-ends, providing different capacitor configurations. For example, the same front-end can be used as a sensor or as switch, depending on the back-end being used.

The front-ends and back-ends can be interchangeable. The sense front-end can be decoupled from the switch back-end, and there is the possibility to insert test and calibration functions. For example, on-board diagnosis and calibration can be provided. The method may comprise providing a connection for a further device, for connecting the electrodes (for example in series or in parallel) to the further device. The connection may be adapted to provide a signal to e.g. an output stage, for providing a signal readout. The signal may be e.g. a voltage, and the signal readout may be representative of the magnetic field sensed. Thus, a sensing device can be provided. If the output stage requires the voltage, the electrodes may be connected in series, thus optimizing the voltage signal. Alternatively, the connection may be adapted to open or close a transistor, thus providing switching functionality.

In some embodiments, the method may comprise providing the further device (e.g. the output stage, e.g. the transistor), for example connecting the further device to the electrodes as described above, being adapted to provide the required action. For example, the transistor may be provided with the connection so that the transistor switches on or off depending on the magnetic field through the transducer. Thus, following the method of the present invention, a magnetic sensor and/or a magnetic switch can be provided, as disclosed in the first aspect of the present invention.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A transducer comprising
- a piezoelectric layer (110),
- at least one pair of magnetic structures (151, 152) attached to the piezoelectric layer (110) and comprising high permeability material, the structures defining a gap between them, and being shaped and positioned relative to each other, such that strain is generated therebetween on the piezoelectric layer when the pair of magnetic structures is subjected to an external magnetic field,
wherein the piezoelectric layer is configured to generate charges as a response to its mechanical strain from the forces of the magnetic structures,
- further comprising at least one pair of electrodes (141, 142) isolated by the piezoelectric material, each electrode of the pair being positioned to collect charges of opposite sign generated by the piezoelectric layer, so that a signal can be provided by the transducer without external electrical power sources, thus providing a passive magneto-electric transducer.

2. The transducer of the previous claim further comprising lateral stress release cuts (280, 380) in the piezoelectric layer to increase flexibility.

3. The transducer of any one of the previous claims further comprising a planar rigid substrate (130) and a flexible layer (120) sandwiched between the piezoelectric layer (110) and the planar rigid substrate (130), for providing mechanical decoupling from the rigid substrate (130).

4. The transducer of the previous claim wherein the flexible layer (120) comprises elastic polyimide, benzocylobutene, polybenzoxazole, acryl, fluoroslicone, silicone or siloxane

5. The transducer of any one of the previous claims wherein a first electrode (141) of the pair is provided on a first surface of the piezoelectric layer (110) between the pair of magnetic structures (151, 152), and a second electrode (142) is provided on the opposite surface of the piezoelectric layer, between the flexible layer and the piezoelectric layer.

6. The transducer of any one of the previous claims wherein the electrodes are shaped and positioned relative to magnetic structures (451, 452) so that, when the magnetic field is induced through said pair of magnetic structures, a force is generated between the structures for causing an out-of-plane strain to the piezoelectric layer at least in the region of the piezoelectric layer in electric contact with an electrode.

7. The transducer of any one of the previous claims wherein the magnetic structures comprise Ni, Fe, Co or combinations thereof.

8. The transducer of any one of the previous claims wherein the at least one pair of magnetic structures comprises an array of magnetic structures arranged so that strain is generated on the piezoelectric layer between pairs of the structures when the array is subjected to an external magnetic field.

9. A method of manufacture of a transducer in accordance with any one of the previous claims, comprising
- providing a piezoelectric layer,
- providing at least one electrode in direct contact with the surface of the piezoelectric layer,
- providing at least a pair of magnetic structures on the opposite side surface of the piezoelectric layer, defining a gap between the pair of structures, the structures being arranged so that the structures strain the piezoelectric layer when submitted to a magnetic field,
- connecting the at least one electrode to an output for reading the signals generated by the piezoelectric layer.

10. The method of the previous claim, further comprising providing a rigid substrate and further providing a flexible layer between the piezoelectric layer and the rigid substrate.

11. The method of the previous claim wherein providing the flexible layer comprises spin coating or laminating polymer on top of the substrate or on top of the piezoelectric layer.

12. The method of any one of claims 9 to 11, wherein providing the magnetic structures comprises providing magnetic structures configured to provide in-plane stress to the piezoelectric layer and wherein providing at least one electrode comprises providing an electrode pair comprising a first electrode contacting a first surface of the piezoelectric layer, the first electrode being provided within the gap between said magnetic structures, and providing a second electrode contacting the second surface of the piezoelectric layer opposite to the first surface, wherein the first and second electrodes are positioned to collect charges of opposite sign generated at the piezoelectric layer.

13. The method of any one of claims 9 to 11, wherein providing the magnetic structures comprises providing magnetic structures configured to provide out-of-plane stress to the piezoelectric layer, and wherein providing at least one electrode comprises providing an electrode pair comprising a first electrode and a second electrode contacting a first surface of the piezoelectric layer opposite to the second surface being the surface supporting the magnetic structures, wherein the first and second electrodes are positioned to collect charges of opposite sign from the piezoelectric layer.

14. The method of any one of the previous claims further comprising providing a connection arranged to open or close a transistor.

15. The method of any one of the previous claims further comprising providing a connection for a sensor output stage.
